# EUROPÄISCHE PATENTSCHRIFT

(11) **EP 3 009 852 B1**
(45) Veröffentlichungstag und Bekanntmachung des Hinweises auf die Patenterteilung: **27.11.2019**
(21) Anmeldenummer: 15002913.0
(22) Anmeldetag: 13.10.2015
(51) Int. Cl.: G01R 31/28

(54) **TESTKONTAKTOR, VERWENDUNG EINES TESTKONTAKTORS UND VERFAHREN ZUM PRÜFEN EINER LEITERPLATTE**
TEST CONTACTOR, USE OF A TEST CONTACTOR AND METHOD OF TESTING A CIRCUIT BOARD
CONTACTEUR D'ESSAI, UTILISATION D'UN CONTACTEUR D'ESSAI ET PROCEDE DE VERIFICATION D'UNE CARTE DE CIRCUITS IMPRIMES

(30) Priorität: 13.10.2014 DE 102014015147
(43) Veröffentlichungstag der Anmeldung: 20.04.2016
(73) Patentinhaber: Yamaichi Electronics Deutschland GmbH, 85609 Aschheim-Dornach (DE)
(72) Erfinder: Chakchouk, Skander, 85609 Aschheim-Dornach (DE); Quiter, Michael, 57482 Wenden (DE)
(74) Vertreter: Müller-Boré & Partner Patentanwälte PartG mbB

(56) Entgegenhaltungen:
- DE-A1- 3 405 568
- US-A- 6 084 422
- "Board edge connector family", , 30. November 2013 (2013-11-30), XP055252107, Gefunden im Internet: URL:http://www.yamaichi.de/fileadmin/user_ upload/bilder_und_PDFs/Service/Product_Cat alogues/Yamaichi_Electronics_board_edge_co nnector_nov2013.pdf [gefunden am 2016-02-22]

## Beschreibung

Die Erfindung betrifft einen Testkontaktor, die Verwendung eines Testkontaktors und ein Verfahren zum Prüfen einer Leiterplatte.

Unter einer Leiterplatte wird im Sinne dieser Anmeldung eine Leiterplatte bzw. Platine für eine gedruckte Schaltung verstanden, auch genannt PCB, englisch: "Printed Circuit Board". Eine Leiterplatte kann eine oder mehrere elektrische und/oder elektronische Bauteile wie beispielsweise integrierte Schaltkreise aufweisen, auch genannt IC vom englischen "Integrated Circuit". Weiterhin kann eine Schalterplatte Widerstände, Kondensatoren, Dioden, Transistoren usw. umfassen.

Herkömmlicherweise werden Leiterplatten nach der Herstellung auf ihre Funktionsfähigkeit geprüft. Viele Leiterplatten von gedruckten Schaltungen weisen Platinenrandkontakte auf (englisch: "edge board contact", kurz EBC), so dass die Leiterplatten durch ein Einführen ihres Randes in einen Platinenverbinder elektrisch und mechanisch mit einer Mutterleiterplatte (auch: "motherboard") verbindbar sind. Damit die elektrische und mechanische Verbindung dauerhaft ist, müssen die Kontakte des Platinenverbinders eine vorbestimmte Kontaktkraft auf die Platinenrandkontakte der eingeführten Leiterplatte anlegen, was dazu führt, dass das Einführen mit einem hohen Kraftaufwand erfolgt, welcher notwendig ist, um die Kontakte des Platinenverbinders auseinander zu drücken. Dabei tritt ebenfalls beim Einführen einer Reibung zwischen den Kontakten des Platinenverbinders und den Platinenrandkontakten der Leiterplatte auf.

Zur Prüfung von Leiterplatten werden diese in einen Platinenverbinder einer Prüfplatine geschoben, geprüft und anschließend wieder entfernt. Mitunter findet die Prüfung der Leiterplatten automatisiert in Prüfautomaten statt, so dass die einzelnen für die Prüfung notwendigen Betriebszustände durch den Prüfautomaten herstellbar sein sollten.

Aus dem Dokument DE 10 2011 016 299 A1 ist ein Testkontaktor für eine Leiterplatte bekannt, in dem eine zu prüfende Leiterplatte senkrecht mit derjenigen Seitenkante zuerst einsteckbar ist, an der die Platinenrandkontakte ausgebildet sind. Die Leiterplatte wird zwischen zwei Prüfbacken gesteckt, die anschließend aneinander gedrückt werden und dabei die Platinenrandkontakte kontaktieren. Zur Überprüfung wird die Leiterplatte in der richtigen Position genau in einen dafür vorgesehenen Spalt des Testkontaktors eingesteckt.

Aus dem Dokument DE 34 05 568 A1 ist eine Testvorrichtung zum Kontaktieren und Prüfen von Flachbaugruppen mit männlichen Steckverbindungen bekannt, die von komplementären weiblichen Steckern der Testvorrichtung kontaktiert werden.

Der Katalog "board edge connector family", XP055252107, der als PDF-Datei auf der Homegape von Yamaichi Electronics Deutschland GmbH ausgestellt ist, zeigt in einer Figur einen Testadapter für Platinen mit EBCs, der in der gezeigten Form jedoch nicht zuverlässig funktionierte und deswegen nicht verkauft worden ist.

Der Erfindung liegt die Aufgabe zugrunde, ein verbessertes Überprüfen von Leiterplatten zu ermöglichen, insbesondere ein vereinfachtes und/oder schnelleres Kontaktieren der Leiterplatte zu ermöglichen, ohne dabei die Leiterplatte selber mechanisch zu stark zu belasten.

Diese Aufgabe wird durch den Gegenstand des Anspruchs 1 gelöst.

Ein Aspekt betrifft einen Testkontaktor zum Kontaktieren einer Leiterplatte mit einer ersten Aufnahme zum Aufnehmen einer ersten Seitenkante der Leiterplatte, wobei die erste Aufnahme zumindest ein erstes Kontaktelement zum Kontaktieren eines ersten Platinenrandkontakts an der ersten Seitenkante der Leiterplatte aufweist. Weiterhin weist der Testkontaktor eine zweite Aufnahme zum Aufnehmen einer zweiten Seitenkante der Leiterplatte auf, wobei die zweite Aufnahme zumindest ein zweites Kontaktelement zum Kontaktieren eines zweiten Platinenrandkontakts an der zweiten Seitenkante der Leiterplatte aufweist.

Der Testkontaktor dient zum Kontaktieren und Überprüfen der Leiterplatte auf eine vorbestimmte, fehlerfreie Funktionalität der Leiterplatte. Der Testkontaktor ist dazu ausgebildet und vorgesehen, Leiterplatten zu überprüfen, die Platinenrandkontakte an mehr als einer Seitenkante aufweisen. Die Leiterplatte weist an der ersten Seitenkante die üblichen Platinenrandkontakte auf, die derart ausgebildet sind, dass sie durch ein Einführen in einen Platinenverbinder elektrisch und mechanisch mit einer Mutterleiterplatte verbindbar sind. Zusätzlich weist die zu überprüfende Leiterplatte an der zweiten Seitenkante zumindest einen zweiten Platinenrandkontakt auf. Dieser zweite Platinenrandkontakt kann speziell zur Überprüfung im Testkontaktor ausgebildet und vorgesehen sein. Dabei unterscheidet sich die erste Seitenkante der Leiterplatte von der zweiten Seitenkante der Leiterplatte. Insbesondere können einander gegenüber liegende Seitenkanten der Leiterplatte als erste und zweite Seitenkante mit Platinenrandkontakten ausgebildet und vorgesehen sein. Leiterplatten sind üblicherweise im Wesentlichen rechteckig ausgebildet und weisen somit vier Seitenkanten auf, von denen zwei Seitenkanten die erste und die zweite Seitenkanten bilden.

Die erste Aufnahme und/oder die zweite Aufnahme können dabei auch jeweils mehrere Kontaktelemente aufweisen, die zum Kontaktieren von mehreren ersten bzw. zweiten Platinenrandkontakten der ersten bzw. zweiten Seitenkante der Leiterplatte ausgebildet und vorgesehen sind.

Die erste Aufnahme kann dabei durch eine Bewegung zweier Backen in Richtung aufeinander zu schließbar sein, so dass der oder die ersten Platinenrandkontakt(e) an der ersten Seitenkante der Leiterplatte besonders schonend von dem oder den ersten Kontaktelement(en) kontaktierbar sind.

Die erste und zweite Aufnahme sind dabei so ausgebildet, dass die Leiterplatte kraftfrei einbringbar ist, insbesondere reibungsfrei. Dazu weist die erste und/oder zweite Aufnahme jeweils eine Aufnahmeöffnung auf, die weiter ist als die Dicke der ersten und/oder zweiten Seitenkante der Leiterplatte.

Kontaktieren bedeutet im Rahmen dieser Anmeldung ein elektrisches und mechanisches Kontaktieren.

Die erste und/oder zweite Aufnahme sind dazu ausgebildet und vorgesehen, die erste bzw. zweite Seitenkante der Leiterplatte zumindest teilweise aufzunehmen. Die erste und/oder zweite Aufnahme sind dabei so ausgebildet, dass sie zumindest den Teil der Seitenkante aufnehmen, an dem die jeweiligen Platinenrandkontakte ausgebildet sind.

Der oder die zweiten Platinenrandkontakt(e) der Leiterplatte können zum Beispiel lediglich auf einer Seite der Leiterplatte ausgebildet sein, zum Beispiel auf der Unterseite oder auf der Oberseite der Leiterplatte. Dementsprechend können auch der oder die zweite(n) Kontaktelement(e) der zweiten Aufnahme auf lediglich einer Kontaktseite der Aufnahme ausgebildet sein.

Die erste und/oder zweite Aufnahme kann zum Kontaktieren der jeweiligen Seitenkante der Leiterplatte zwei flächige Backen aufweisen, die eine zum Überprüfen in die jeweilige Aufnahme eingeführte Seitenkante der Leiterplatte von der Ober- und der Unterseite der Leiterplatte her kontaktieren können. Die beiden flachen Backen können dabei von zwei einander bezüglich der Seitenkante der Leiterplatte gegenüberliegenden Seiten an die Seitenkante gedrückt werden, so dass die jeweilige Seitenkante in der jeweiligen Aufnahme eingeklemmt ist.

Der oder die zweiten Platinenrandkontakte der Leiterplatte können speziell zum Testen im Testkontaktor ausgebildet und vorgesehen sein. Deswegen können die zweiten Platinenrandkontakte größer ausgebildet sein als die ersten Platinenrandkontakte, die zum Einführen in einen Platinenverbinder einer Mutterleitplatte vorgesehen sind. Durch die größere Ausbildung der zweiten Platinenrandkontakte können diese einfacher von Kontakten des Testkontaktors kontaktiert werden, die zweiten Kontaktelemente der zweiten Aufnahme können hierfür gröber ausgebildet sein als solche, die auf die feinen ersten Kontaktelemente abgestimmt sind. Weiterhin muss die zweite Aufnahme die zweite Seitenkante der Leiterplatte nicht so schonend behandeln, wie die erste Aufnahme die erste Seitenkante. Dies vereinfacht und verringert die Anforderungen an die Ausbildung und Ausformung der zweiten Aufnahme. Der Testkontaktor kann als ein BEC-HS-Test-Adapter ausgebildet sein, als ein "Board Edge Connector"-"High Speed"-Testadapter.

Der Testkontaktor ist als eigenständiges Bauteil ausgebildet, separat von der Leiterplatte. Der Testkontaktor ist zur Überprüfung mehrerer, austauschbarer Leiterplatten ausgebildet und vorgesehen. Insofern beziehen sich alle Angaben bezüglich der Leiterplatte auf eine beliebige, in Sollposition angeordnete Leiterplatte, die zur Überprüfung im Testkontaktor geeignet ist. Dazu sollte die Leiterplatte zumindest einen Plattenrandkontakt an zwei unterschiedlichen Seitenkanten aufweisen.

Gemäß einer Ausführungsform sind die erste Aufnahme und die zweite Aufnahme an bezüglich der Leiterplatte gegenüberliegenden Seiten angeordnet. Dadurch wird die Leiterplatte beim Überprüfen vom Testkontaktor besonders sicher gehalten, insbesondere sicherer als bei der Kontaktierung einander benachbarter Seitenkanten der Leiterplatte. Hierbei kann die Leiterplatte vollständig in den Testkontaktor eingebracht werden, wobei die Leiterplatte an den zwei einander gegenüberliegenden Seitenkanten der Leiterplatte im Testkontaktor fixiert wird.

Die zweite Seitenkante, die der ersten Seitenkante der Leiterplatte gegenüberliegt, wird im Nutzungszustand der Leiterplatte, also wenn diese in einen Platinenverbindern einer Mutterleiterplatte eingesteckt ist, oft nicht benutzt. An diesem Ende ausgebildete zweite Platinenrandkontakte stören somit an dieser Position am wenigsten und die Wahrscheinlichkeit, dass solche zusätzlichen Platinenrandkontakte andere elektrische Bauelemente kontaktieren, ist gering.

Gemäß einer Ausführungsform sind in einer Offenposition des Testkontaktors die erste und die zweite Aufnahme geöffnet, so dass die Leiterplatte in die erste und zweite Aufnahme einbringbar ist. In einer Betriebsposition des Testkontaktors sind die erste und die zweite Aufnahme geschlossen, so dass die Leiterplatte mechanisch gegen Entnahme aus dem Testkontaktor gesichert ist. Der Testkontaktor ist dazu ausgebildet und vorgesehen, von der Offenposition in die Betriebsposition überführt zu werden, und umgekehrt. In der Offenposition kann die Leiterplatte insbesondere kraftfrei und/oder reibungsfrei in die erste und zweite Aufnahme einbringbar sein. In der Offenposition des Testkontaktors muss noch keine elektrische Kontaktierung bereitgestellt werden. In der Betriebsposition sind die erste und zweite Aufnahme geschlossen und die ersten und zweiten Platinenrandkontakte der Leiterplatte können kontaktiert werden mittels der ersten und zweiten Kontaktelemente des Testkontaktors. In der Offenposition können flache Auflagebacken der ersten und/oder zweiten Aufnahme voneinander beabstandet angeordnet sein, die in der Betriebsposition die erste und zweite Seitenkante der Leiterplatte zumindest teilweise einklemmen.

In der Betriebsposition des Testkontaktors kann die Funktionalität und/oder die Integrität der Leiterplatte mittels des Testkontaktors überprüft werden. Dazu können über die ersten und zweiten Kontaktelemente Strompulse an die ersten und zweiten Platinenrandkontakte der Leiterplatte angelegt und/oder abgegriffen bzw. gemessen werden. Die gemessenen Stromsignale können mit für die Leiterplatte spezifischen Sollwerten verglichen werden, um die Funktionalität der Leiterplattezu überprüfen.

In einer Weiterbildung dieser Ausführungsform sind die erste und zweite Aufnahme zumindest teilweise sockelartig ausgebildet, so dass die Leiterplatte in der Offenposition im Wesentlichen horizontal auf die erste und zweite Aufnahme auflegbar ist. Dabei kann insbesondere eine erste Auflagebacke der ersten Aufnahme und eine zweite Auflagebacke der zweiten Aufnahme als Auflagesockel für die erste bzw. zweite Seitenkante der Leiterplatte ausgebildet sein. In der Offenposition kann die Leiterplatte somit einfach auf die geöffnete erste und zweite Aufnahme des Testkontaktors aufgelegt werden, was ein besonders einfaches und schnelles Einbringen der Leiterplatte in den Testkontaktor ermöglicht. Ein mühseliges und exaktes Einfädeln bzw. Einstecken in einen Testschlitz entfällt dabei. Die Leiterplatte kann einfach auf den Testkontaktor aufgelegt werden, wobei gegebenenfalls mechanische Führungselemente des Testkontaktors vorgesehen sein können, die ein Verrutschen der Leiterplatte an deren Kanten und Ecken verhindert und die Position der Leiterplatte definiert, in der sich die Leiterplatte befinden soll, wenn der Testkontaktor von der Offenposition in die Betriebsposition überführt wird. Die Führungselemente definieren somit eine Sollposition der Leiterplatte in der Offenposition des Testkontaktors.

Ein horizontales Einbringen, also Auflegen der Leiterplatte auf den Testkontaktor in dessen Offenposition, erfolgt im Wesentlichen ohne Auftreten von Reibungskräften, die die Leiterplatte mechanisch belasten würden. Insbesondere muss keine Seitenkante der Leiterplatte in einen Klemmsitz eingeführt werden, sondern die Leiterplatte wird lediglich auf die erste und zweite sockelartige Aufnahme aufgelegt. Durch das Auflegen der Leiterplatte wird die Leiterplatte bereits in und/oder an dem Testkontaktor gehalten.

Die erste und/oder zweite Aufnahme kann dabei eine oder zwei abgefederte Andruckfläche(n) aufweisen, die eine besonders schonendes Einklemmen der Leiterplatte in der oder den jeweiligen Aufnahmen ermöglicht. Die abgefederte Andruckfläche kann insbesondere als schwebende Auflagefläche ("floating base") ausgebildet sein und zur besonders schonenden Lagerung der Leiterplatte dienen.

In einer Weiterbildung der Ausführungsform weist der Testkontaktor einen Hebel auf, wobei eine Betätigung des Hebels den Testkontaktor von der Offenposition in die Betriebsposition überführt. Der Hebel kann als ein schwenkbarer oder ein parallel versetzbarer Hebel ausgebildet sein. Bei Betätigung des Hebels schließt sich die erste Aufnahme um die erste Seitenkante der Leiterplatte und die zweite Aufnahme um die zweite Seitenkante der Leiterplatte. Eine Betätigung des Hebels kann insbesondere ein Durchführen einer Schwenkbewegung des Hebels sein, oder ein Andrücken eines parallel versetzbaren Hebels an den Testkontaktor. Der Hebel ist weiterhin so ausgebildet, dass er wieder zurückbetätigt werden kann, wobei der Testkontaktor von der Betriebsposition in seine Offenposition überführt wird, in der die Leiterplatte wieder entnehmbar ist.

In einer Weiterbildung dieser Ausführungsform ist die erste Aufnahme an einer Schwenkachse des Hebels ausgebildet. Dabei ist die erste Aufnahme so positioniert, dass sie bei einer Schwenkbewegung des Hebels geschlossen wird, also in die Betriebsposition überführt wird. Hierbei bedeutet der Ausdruck "an der Schwenkachse", dass die erste Aufnahme durch Druckbeaufschlagung vom Hebel geschlossen wird, und zwar durch Druckbeaufschlagung von einer Stelle des Hebels, die weniger als 20%, insbesondere weniger als 10% seiner Hebellänge von der Schwenkachse beabstandet ist. An dieser Stelle ist die Hebelbewegung nicht so stark ausgeprägt wie an einem Hebelende, das an dem der Schwenkachse gegenüberliegenden Ende des Hebels ausgebildet ist.

In einer Weiterbildung der Ausführungsform ist die zweite Aufnahme in der Betriebsposition von einem Hebelende des Hebels geschlossen. Dabei wird die zweite Aufnahme insbesondere von dem der Schwenkachse des Hebels beabstandeten Hebelende geschlossen. Das Hebelende kann als ein Verschluss ausgebildet sein, zum Beispiel in Form einer flachen Backe, die in der Betriebsposition auf die zweite Seitenkante drückt, welche auf einer entsprechenden Gegenbacke der zweiten Aufnahme abgestützt ist. Diese Gegenbacke der Aufnahme kann zum Beispiel sockelartig ausgebildet sein. In der Betriebsposition ist die zweite Seitenkante der Leiterplatte in einem Klemmsitz zwischen einem statisch fixierten Bauteil der zweiten Aufnahme (z.B. einer Auflagebacke) und dem Hebelende des Hebels in einem Klemmsitz gehalten. Der Hebel muss nicht unbedingt an der Position der zweiten Aufnahme enden, sondern kann zum Beispiel aus ergonomischen Gründen über die zweite Aufnahme herausstehend ausgebildet sein.

Allgemeiner kann ein Hebelteil die erste Aufnahme verschließen und öffnen, während ein zweiter Hebelteil die zweite Aufnahme öffnet und verschließt. Somit werden beide Aufnahmen durch Betätigung desselben Hebels geschlossen und geöffnet.

In einer Weiterbildung dieser Ausführungsform weist der Testkontaktor einen fehlenden Rasthaken auf, der den Hebel in der Betriebsposition sichert und bei Druckbeaufschlagung freigibt. Der Rasthaken kann am Hebelende und/oder der zweiten Aufnahme ausgebildet sein. Eine schräge Rastnase des Rasthakens kann zum automatischen Auslenken des Rasthakens bei Betätigung des Hebels in die geschlossene Betriebsposition dienen. Somit wird der Hebel bei Betätigung automatisch verrastet und in der Betriebsposition gesichert und/oder gehalten. Um den Testkontaktor wieder in die Offenposition zu überführen, kann ein Benutzer leicht auf den Rasthaken drücken, der mittels Federkraft vorgespannt sein kann. Bei Druckbeaufschlagung gegen diese Vorspannung gibt der Rasthaken den Hebel frei und der Hebel kann zurückbetätigt werden in die Offenposition des Testkontaktors.

In einer Weiterbildung dieser Ausführungsform weist der Testkontaktor ein Federelement auf, das eine Kraft auf den Hebel in diejenige Hebelposition ausübt, in der der Testkontaktor in der Offenposition angeordnet ist. Ohne weitere Krafteinwirkung schwenkt der Hebel somit automatisch in die Offenposition. Das Federelement stellt somit eine Vorspannung auf dem Hebel bereit, die den Hebel ohne weitere Krafteinwirkung in die Offenposition drückt. Die Federkraft kann dabei so bemessen sein, dass sie zumindest 140% der Gewichtskraft des Hebels beträgt, die an der Position des Federelements wirkt.

In einer Weiterbildung kann der Hebel als schwenkbarer Deckel des Testkontaktors ausgebildet sein. Eine Schwenkbewegung des Deckels entspricht etwa einer Klappbewegung. Dabei kann der Deckel lediglich einen stabilen Rahmen aufweisen und/oder aus diesem bestehen, ohne massiv ausgebildet zu sein.

Gemäß einer Ausführungsform ist die zweite Aufnahme dazu ausgebildet und vorgesehen, den zweiten Platinenrandkontakt mit einer Stromquelle zu verbinden. Dabei ist das zweite Kontaktelement mit der Stromquelle verbunden, und dazu ausgebildet und vorgesehen, die zu überprüfende Leiterplatte mit Strom zu beaufschlagen. Die daraus resultierenden Stromwerte an der oder den ersten Platinenrandkontakten können an der ersten Aufnahme gemessen werden.

Gemäß einer Ausführungsform weist die zweite Aufnahme schräge Rutschflächen auf. Die Rutschflächen ermöglichen ein einfaches Eindringen der Leiterplatte in den Testkontaktor. Die Rutschflächen können dabei so ausgebildet sein, dass eine auf die Rutschflächen aufgelegte Leiterplatte automatisch in eine Sollposition rutscht, in welcher sich die Leiterplatte befinden soll, wenn der Testkontaktor zum Überprüfen der Leiterplatte geschlossen wird. Dabei kann die zweite Aufnahme eine oder mehrere solcher schrägen Rutschflächen aufweisen.

Gemäß einer Ausführungsform ist an der ersten Aufnahme zumindest ein Pin zur Ausrichtung der ersten Seitenkante der Leiterplatte in der ersten Aufnahme angeordnet. Dazu kann die Leiterplatte an der ersten Seitenkante einen entsprechenden Einführspalt aufweisen, in dem der Pin beim Einbringen der ersten Seitenkante der Leiterplatte in die erste Aufnahme eingreift. Der Pin ermöglicht ein Überprüfen der korrekten Einbringung der Leiterplatte in den Testkontaktor und richtet die Leiterplatte so aus, dass sie in einer Sollposition angeordnet ist.

Gemäß einer Ausführungsform ist an der zweiten Aufnahme zumindest ein Pin zur Ausrichtung der zweiten Seitenkante der Leiterplatte in der zweiten Aufnahme angeordnet. Entsprechend kann in der zweiten Seitenkante ein Einführspalt in der Leiterplatte ausgebildet sein, in den der Pin eingreift, wenn die Leiterplatte korrekt in einer Sollposition in den Testkontaktor eingebracht wird.

In einer Weiterbildung der Ausführungsform greift der Pin zur Ausrichtung der zweiten Seitenkante der Leiterplatte in der Betriebsposition in einen Eingriff am Hebelende ein, der als Verschluss der zweiten Aufnahme ausgebildet ist. Der Pin erfüllt somit gleichzeitig zwei Funktionen: Zum einen dient er zum Ausrichten der zweiten Seitenkante der Leiterplatte und zum korrekten Ausrichten des Hebelendes auf der zweiten Aufnahme.

Ein Aspekt betrifft die Verwendung eines Testkontaktors gemäß dem oben beschriebenen Aspekt zum Kontaktieren einer Leiterplatte, wobei die erste Seitenkante der Leiterplatte in der ersten Aufnahme angeordnet ist und die zweite Seitenkante der Leiterplatte in der zweiten Aufnahme angeordnet ist.

Ein Aspekt betrifft ein Verfahren zum Prüfen einer Leiterplatte mit den Schritten:
- Bereitstellen eines geöffneten Testkontaktors gemäß dem eingangs beschriebenen Aspekt;
- Anordnen einer Leiterplatte derart, dass die erste Seitenkante der Leiterplatte in der ersten Aufnahme angeordnet ist und die zweite Seitenkante der Leiterplatte in der zweiten Aufnahme;
- Schließen des Testkontaktors derart, dass das erste Kontaktelement den ersten Platinenrandkontakt kontaktiert und das zweite Kontaktelement den zweiten Platinenrand kontaktiert;
- Prüfen der Leiterplatte;
- Öffnen des Testkontaktors und
- Entnehmen der Leiterplatte.

Ein weiterer Aspekt betrifft eine Leiterplatte mit einer ersten Seitenkante, an der ein erster Platinenrandkontakt ausgebildet ist, der dazu ausgebildet und vorgesehen ist, in einen Platinenverbinder eingeführt zu werden und dadurch elektrisch und mechanisch mit einer Mutterleitplatte verbindbar ist. Die Leiterplatte weist weiterhin an einer zweiten Seitenkante der Leiterplatte einen zweiten Platinenrandkontakt auf, wobei der zweite Platinenrandkontakt dazu ausgebildet und vorgesehen ist, in einem Testkontaktor eingebracht und von diesem kontaktiert zu werden. Dies kann insbesondere ein Testkontaktor gemäß dem eingangs beschriebenen Aspekt sein.

Die Erfindung wird nachfolgend anhand von einem in Figuren beschriebenen Ausführungsbeispiel näher beschrieben. Es zeigen:
- Figur 1A: eine perspektivische Zeichnung eines Testkontaktors in einer Betriebsposition mit einer Leiterplatte in Sollposition;
- Figur 1B: eine perspektivische Zeichnung eines Testkontaktors in einer Offenposition mit Leiterplatte in Sollposition;
- Figur 2: eine Zeichnung einer Leiterplatte von unten;
- Figur 3A: in einer Zeichnung einen Querschnitt durch eine erste Aufnahme eines Testkontaktors mit aufgelegter Leiterplatte in Offenposition;
- Figur 3B: in einer Zeichnung einen Querschnitt durch eine erste Aufnahme eines Testkontaktors mit eingeklemmter Leiterplatte in Betriebsposition;
- Figur 4A: in einer Zeichnung einen Querschnitt durch eine zweite Aufnahme eines Testkontaktors mit kontaktierter Leiterplatte in Offenposition;
- Figur 4B: in einer Zeichnung einen Querschnitt durch eine zweite Aufnahme eines Testkontaktors mit kontaktierter Leiterplatte in Betriebsposition;
- Figur 5A: in einer Zeichnung einen Querschnitt durch einen Testkontaktor mit aufgelegter Leiterplatte in Offenposition und
- Figur 5B: in einer Zeichnung einen Querschnitt durch einen Testkontaktor mit kontaktierter Leiterplatte in Betriebsposition.

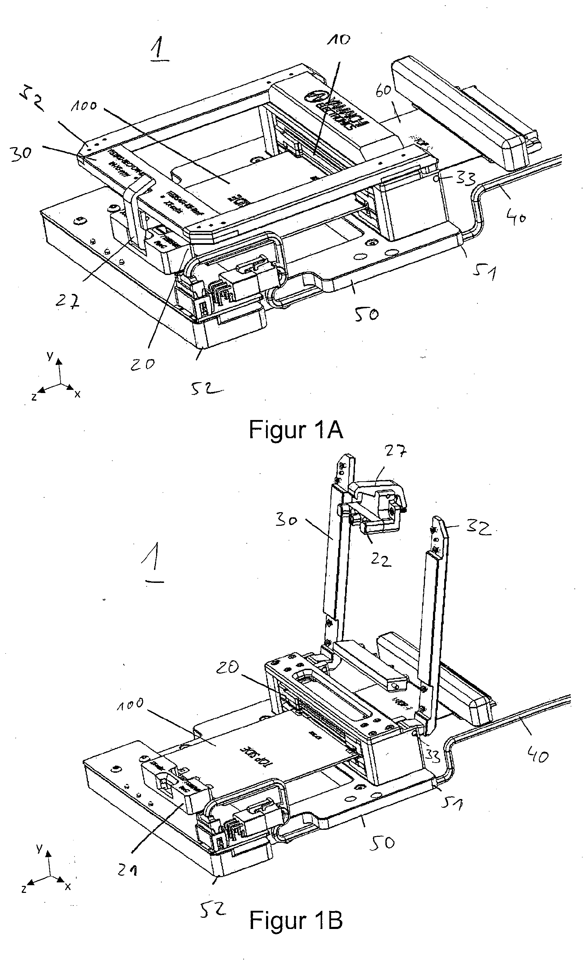

**Figur 1A** zeigt einen Testkontaktor 1, in den eine Leiterplatte 100 eingebracht ist. Der Testkontaktor 1 weist einen Testkontaktorboden 50 auf, der flächig ausgebildet ist und als Auflagefläche des Testkontaktors 1 ausgebildet ist. Ein Kabel 40 kann an eine Stromquelle angeschlossen sein und dient zur elektrischen Kontaktierung einer zweiten Aufnahme 20. Der Testkontaktor 1 weist eine erste Aufnahme 10 und eine zweite Aufnahme 20 auf.

**Figur 1B** zeigt den in Figur 1A gezeigten Testkontaktor 1 in einer Offenposition. In der Offenposition ist ein Hebel 30 des Testkontaktors 1 geöffnet, der in der in Figur 1A dargestellten Betriebsposition des Testkontaktors 1 geschlossen ist. Der Hebel 30 ist um eine Schwenkachse 33 schwenkbar. Ein Hebelende 32 des Hebels 30 ist an dem Hebelende angeordnet, dass der Schwenkachse 33 gegenüberliegt. Das Hebelende 32 ist an der Position des Hebels 30 angeordnet, dass sich bei Betätigung des Hebels am meisten relativ zum Testkontaktorboden 50 bewegt.

In der in Figur 1A gezeigten Betriebsposition des Testkontaktors liegt das Hebelende 32 auf der zweiten Aufnahme 20 auf. Das Hebelende 32 ist in der Betriebsposition durch einen Rasthaken 27 gesichert, so dass der Hebel 30 nicht zurückschwenken kann. Ein in den Figuren 1A und 1B nicht gezeigtes Federelement kann eine Vorspannung auf den Hebel 30 bereitstellen, die den Hebel 30 ohne weitere Krafteinwirkung in die in Figur 1B gezeigte Offenposition schwenkt. In der Betriebsposition verhindert der eingerastete Rasthaken 27 ein Zurückschwenken des Hebels 30 in die Offenposition.

In der in Figur 1B gezeigten Offenposition des Testkontaktors 1 ist die Leiterplatte 100 bereits in Sollposition. Die Sollposition der Leiterplatte 100 entspricht dabei der Position der Leiterplatte 100 relativ zum Testkontaktor 1, in der die Leiterplatte überprüft werden kann. Somit entspricht die Sollposition der Leiterplatte 100 der Position, in der sie sich in Betriebsposition des Testkontaktors angeordnet ist (vgl. Figur 1A). Befindet sich die Leiterplatte 100 in ihrer Sollposition, kann der Testkontaktor 1 geschlosssen werden.

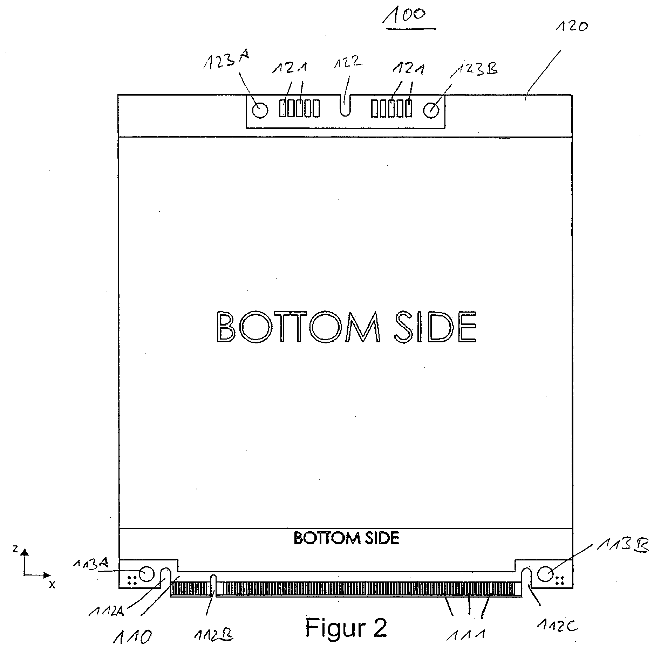

**Figur 2** zeigt die Leiterplatte 100 von ihrer Unterseite. Die Leiterplatte 100 ist im Wesentlichen als rechteckige Platte aufgebaut und weist insgesamt vier Seitenkanten auf. Die Leiterplatte 100 kann als PCB ausgebildet sein und weist an einer ersten Seitenkante 110 erste Platinenrandkontakte 111 auf. Die Leiterplatte 100 ist dazu ausgebildet und vorgesehen, mit der ersten Seitenkante 110 in einen Platinenverbinder einer Mutterleiterplatte eingeführt zu werden. In einem solchen Platinenverbinder werden die ersten Platinenrandkontakte 111 in einem Klemmsitz festgehalten. Der Platinenverbinder kann sowohl zum elektrischen Kontaktieren der Platinenrandkontakte 111 dienen, als auch zum Fixieren der Leiterplatte 100 in einer lediglich mit der ersten Seitenkante 110 eingesteckten Position.

Die ersten Platinenrandkontakte können als beidseitige elektrische Kontakte ausgebildet sein, die sowohl an der in Figur 2 gezeigten Unterseite als auch an der Gegenseite, also der Oberseite der Leiterplatte 100, elektrisch kontaktierbar sind.

In der ersten Seitenkante 110 sind Einführspalte 112A, 112B und 112C ausgebildet, die zum geregelten Einführen der ersten Seitenkante 110 dienen. Dabei ist einer der Einführspalte 112B asymmetrisch angeordnet, um zu gewährleisten, dass die Leiterplatte 100 nur auf eine vorbestimmte Weise hin ausgerichtet eingesteckt wird. An der ersten Seitenkante 110 sind an den Seitenrändern weiterhin Fixieröffnungen 113A und 113B ausgebildet, in die ein Pin der ersten Aufnahme 10 eingreifen kann.

Eine zweite Seitenkante 120 der Leiterplatte 100 ist an der Seitenkante der Leiterplatte 100 angeordnet, die der ersten Seitenkante 110 gegenüberliegt. Die zweite Seitenkante 110 weist mehrere zweite Platinenseitenrandkontakte 121 auf. Die zweiten Platinenseitenrandkontakte 121 sind dazu ausgebildet und vorgesehen, in der zweiten Aufnahme 20 des Testkontaktors 1 kontaktiert zu werden. Die zweiten Platinenrandkontakte 121 können größer und stabiler als die ersten Platinenrandkontakte 111 ausgebildet sein. Die zweiten Platinenrandkontakte 121 können lediglich ein einer Seite ausgebildet sein, z.B. an der Unterseite, oder als beidseitige Platinenrandkontakte an der Ober- und Unterseite der Leiterplatte 100 ausgebildet sein.

In der in Figur 2 gezeigten Ausführungsform weist die Leiterplatte 100 insgesamt zehn zweite Platinenrandkontakte 121 auf, die in zwei Gruppen zu je fünf zweiten Platinenrandkontakten 121 angeordnet sind, die symmetrisch bezüglich der Mitte der Leiterplatte 100 angeordnet sind. Eine der beiden symmetrisch angeordneten Gruppen von zweiten Platinenrandkontakten 121 kann dazu ausgebildet und vorgesehen sein, mit dem Pluspol einer Stromquelle verbunden zu werden, während die andere Gruppe von zweiten Platinenrandkontakten 121 dazu ausgebildet und vorgesehen sein kann, mit dem Minuspol verbunden zu werden.

In der zweiten Seitenkante 120 ist ein Einführspalt 122 ausgebildet. In der in Figur 2 gezeigten Ausführungsform ist der Einführspalt 122 zentral in der Mitte der zweiten Seitenkante 120 ausgebildet. In alternativen Ausführungsformen kann der Einführspalt dezentral angeordnet sein und/oder die zweiten Seitenkante 120 kann einen oder mehrere weitere Einführspalte aufweisen.

Weiterhin sind in der zweiten Seitenkante 120 Fixieröffnungen 123A und 123B angeordnet, die die Leiterplatte 100 durchdringen und im Wesentlichen als kreisrunde Löcher ausgebildet sein können.

In Sollposition der Leiterplatte 100 befindet sich die erste Seitenkante 110 in der ersten Aufnahme 10 des Testkontaktors 1 und die zweite Seitenkante 120 in der zweiten Aufnahme 20.

In den Figuren 1A und 1B ist die in Figur 2 gezeigte Leiterplatte 100 mit der ersten Seitenkante 110 in die erste Aufnahme 10 eingeführt, während die zweite Seitenkante 120 in die zweite Aufnahme 20 des Testkontaktors 1 eingeführt ist.

Ähnlich wie die Leiterplatte 100 weist der Testkontaktor 1 einen im Wesentlichen rechteckigen Grundriss auf, der allerdings größer als der Grundriss der Leiterplatte 100 ausgebildet ist. Insbesondere weist der Testkontaktorboden 50 eine im Wesentlichen rechteckige Bodenauflagefläche auf. Eine erste Bodenkante 51 des Testkontaktorbodens 50 ist parallel angeordnet zur ersten Seitenkante 110 der Leiterplatte 100 in Sollposition. In Sollposition der Leiterplatte 100 ist auch eine zweite Bodenkante 52 des Testkontaktorbodens 50 parallel zur zweiten Seitenkante 120 angeordnet.

Die erste Aufnahme 10 ist an und parallel zu der ersten Bodenkante 51 des Testkontaktorbodens 50 angeordnet. Die zweite Aufnahme 20 ist an und parallel zu der zweiten Bodenkante 52 des Testkontaktorbodens angeordnet.

In der Offenposition des Testkontaktors (vgl. Figur 1B) ist der Hebel 30 soweit geöffnet, dass die Leiterplatte 100 bequem einführbar ist, ohne mit dem Hebel 30 zu kollidieren. Der Hebel 30 ist rahmenförmig ausgebildet und bildet einen Deckel des Testkontaktors 1, der in der Betriebsposition oberhalb und parallel zum Testkontaktorboden 50 angeordnet ist. In der Sollposition ist die Leiterplatte 100 zwischen und parallel zum Testkontaktorboden 50 angeordnet. In Betriebsposition des Testkontaktors 1 ist die Leiterplatte 100 zudem parallel zum Hebel 30 angeordnet.

Die zweite Aufnahme 20 weist eine zweite Auflagebacke 21 auf (vgl. Figuren 1A und 1B), die auf dem Testkontaktorboden 50 angeordnet ist und an diesem befestigt sein kann. Die zweite Auflagebacke 21 stellt eine Auflage für die zweite Seitenkante 120 der Leiterplatte 100 bereit. Die zweite Auflagebacke 21 stellt weiterhin eine Auflagefläche für das Hebelende 32 bereit. Zudem kann die zweite Auflagebacke 21 eine Anlagefläche für die zweite Seitenkante 120 bereitstellen, die die Leiterplatte in ihrer Sollposition fixiert.

Am zweiten Hebelende 32 ist eine zweite Schließbacke der zweiten Aufnahme angeordnet, die in der Betriebsposition von oben auf die zweite Seitenkante 120 der Leiterplatte 100 drückt.

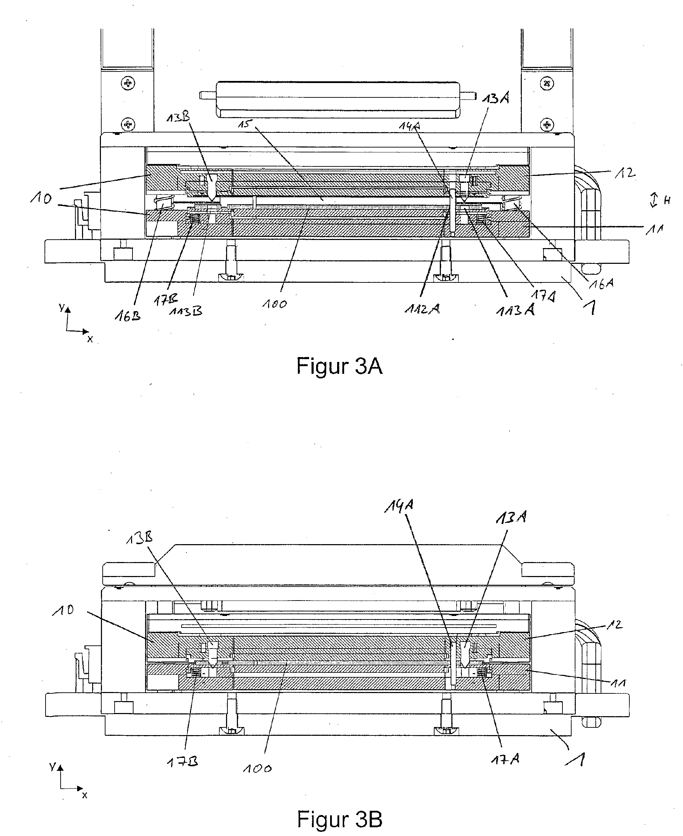

In der Offenposition (vgl. Figur 1B) kann die Leiterplatte 100 einfach auf die erste und zweite Aufnahme aufgelegt werden. Genauer kann die Leiterplatte 100 in der Offenposition auf die zweite Auflagebacke 21 der zweiten Öffnung aufgelegt werden sowie auf eine erste Auflagebacke 11 der ersten Aufnahme 10 (vgl. Figur 3A).

An der ersten Bodenkante 51 ist ein Datenkabel 60 angeordnet, dass elektrisch mit der ersten Aufnahme 10 verbunden ist, genauer mit ersten Kontaktelementen der ersten Aufnahme 10. Über die ersten Kontaktelemente sind die ersten Platinenrandkontakte 111 der Leiterplatte 100 mit dem Datenkabel 60 kontaktierbar.

**Figur 3A** zeigt einen Querschnitt durch die erste Aufnahme 10 parallel zur ersten Bodenkante 51 in der Offenposition des Testkontaktors 1.

**Figur 3B** zeigt den in Fig. 3A gezeigten Querschnitt durch den Testkontaktor 1 in einer geschlossenen Betriebsposition des Testkontaktors 1.

Die erste Aufnahme 10 weist die erste Auflagebacke 11 auf, die am Testkontaktorboden 50 angeordnet ist. Die erste Auflagebacke 11 weist eine Auflagefläche auf, auf die Leiterplatte 100 mit der ersten Seitenkante 110 auflegbar ist.

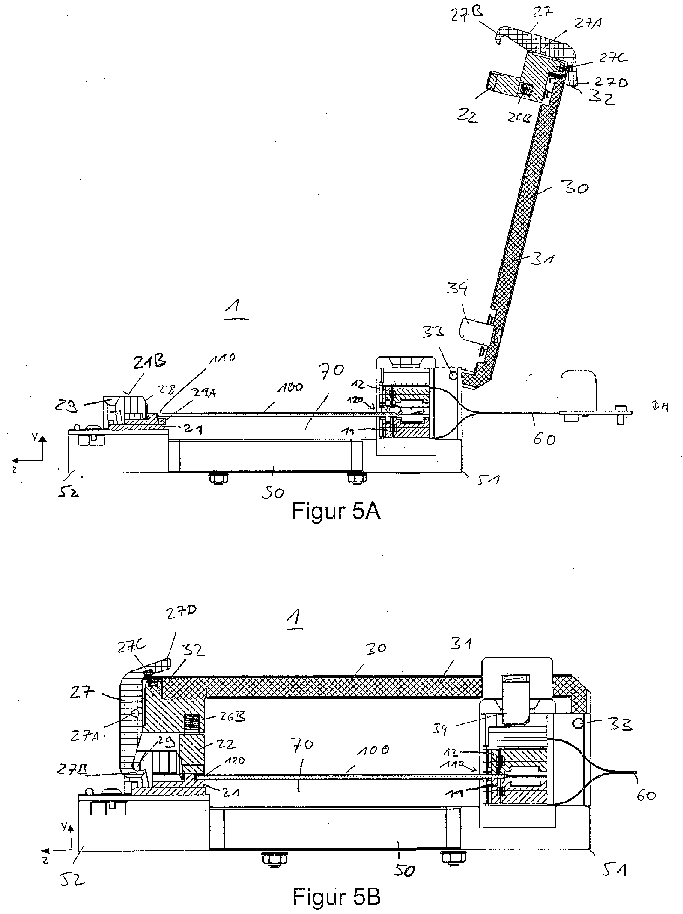

In den Figuren 3A, 3B, 4A, 4B, 5A und 5B ist die Leiterplatte 100 mit einem Punktmuster gekennzeichnet. In den Figuren 3A, 3B, 5A und 5B ist die erste Auflagebacke 11 durch eine schräge Schraffierung gekennzeichnet, die von links unten nach rechts oben verläuft. In den Figuren 3A, 3B, 5A und 5B ist eine erste Schließbacke 12 der ersten Aufnahme 10 durch eine Schraffierung gekennzeichnet, die von links oben nach rechts unten verläuft.

Die erste Aufnahme 10 ist im Wesentlichen zweigeteilt ausgebildet, und weist die erste Auflagebacke 11 auf sowie die erste Schließbacke 12. In der in Figur 3A gezeigten Offenposition des Testkontaktors 1 ist ein Spalt 15 als Aufnahmeöffnung zwischen der ersten Auflagebacke 11 und der ersten Schließbacke 12 ausgebildet, in den die Leiterplatte 100 einführbar ist. Die erste Aufnahme 10 weist Öffnungsfederelemente 16A und 16B auf, die eine Vorspannung bereitstellen, die die erste Schließbacke 12 in der Offenposition beabstandet von der ersten Auflagebacke 11 hält. Wird der Hebel 30 geschlossen, so wird die erste Schließbacke 12 senkrecht nach unten auf die erste Auflagebacke 11 bewegt, entgegen der von den Öffnungsfederelemente 16A und 16B bereitgestellte Vorspannung. Die Bewegung der ersten Schließbacke zu ersten Auflagebacke erfolgt senkrecht aufeinander zu über die Hubhöhe H.

Die erste Aufnahme 10 weist zwei Fixierpins 13A und 13B auf, die in der Betriebsposition in die Fixieröffnungen 113A und 113B an der ersten Seitenkante 110 der Leiterplatte 100 eingreifen und ein seitliches Herausrutschen der Leiterplatte 100 aus der ersten Aufnahme 10 verhindern. Ein Führungspin 14A der ersten Aufnahme 10 greift in den Einführspalt 112A der Leiterplatte 100 ein. Die erste Aufnahme 10 kann weitere Führungspins aufweisen, die in die Einführspalte 112A, 112B und 112C der Leiterplatte 100 eingreifen.

Die erste Aufnahme 10 weist weiterhin innerhalb der ersten Auflagebacke 11 eine Abfederung auf, die in dieser Ausführungsform von Federungen 17A und 17B bereitgestellt wird, die eine abgefederte, schwebende Auflagefläche für die Leiterplatte 100 bereitstellen, als sogenannte "floating base". Die schwebende Auflagefläche wird in der Betriebsposition nach unten gedrückt und verbessert den Klemmsitz der ersten Seitenkante 110 in der Betriebsposition zwischen der ersten Auflagebacke 11 und der zweiten Auflagebacke 12. Die durch die Federungen 17A und 17B bereitgestellte Abfederung wirkt im Wesentlichen senkrecht nach oben, und zwar von unten hin zur die Auflagefläche der ersten Auflagebacke 11.

Die abgefederte, schwebende Auflagefläche der ersten Aufnahme 10 stellt weiterhin eine besonders schonende Auflagefläche für die Leiterplatte 100 bereit, die eine Einbringbewegung der Leiterplatte 100 in den Testkontaktor 1 abfedert.

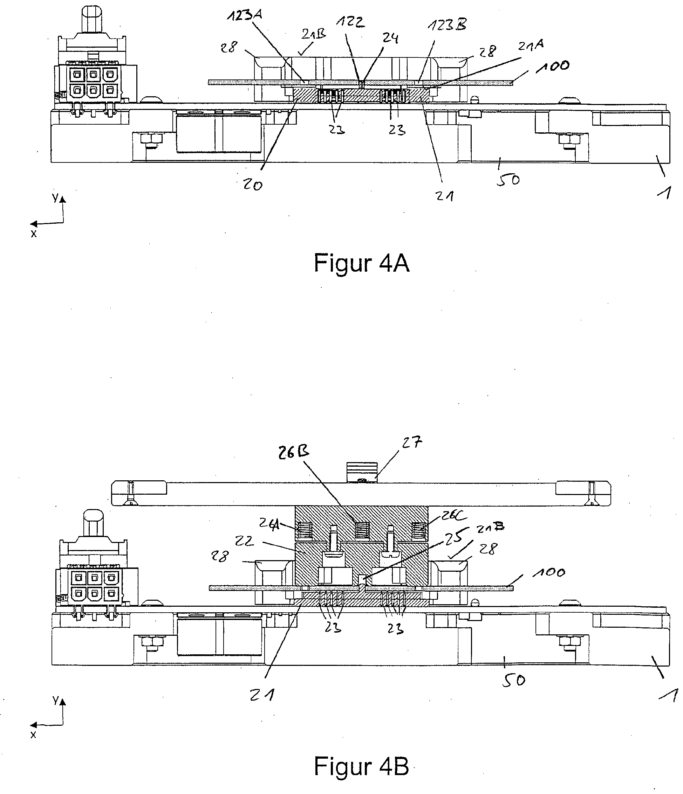

**Figur 4A** zeigt einen Querschnitt durch die zweite Aufnahme 20 des Testkontaktors 1 mit darauf in Sollposition aufgelegter Leiterplatte 100. Der Querschnitt verläuft parallel zur zweiten Bodenkante 52 und parallel zur zweiten Seitenkante 120 der Leiterplatte 100. Figur 4A zeigt den Querschnitt in der Offenposition des Testkontaktors 1.

**Figur 4B** zeigt denselben Querschnitt in Betriebsposition des Testkontaktors 1.

Die zweite Aufnahme 20 weist eine zweite Auflagebacke 21 auf, die auf dem Testkontaktorboden 50 angeordnet ist. Die zweite Schließbacke 22 der zweiten Aufnahme 20 ist an dem Hebelende 32 angeordnet und in Figur 4A nicht zu sehen, sondern lediglich in Figur 4B. Innerhalb der zweiten Auflagebacke 21 sind zweite Kontaktelemente 23 angeordnet, die in Betriebsposition die zweiten Platinenrandkontakte 121 der Leiterplatte 100 kontaktieren. Die zweiten Kontaktelemente 23 sind mit den elektrischen Kontakten des Kabels 40 verbunden (vgl. Figuren 1A und 1B).

In den Figuren 4A, 4B, 5A und 5B ist die zweite Auflagebacke 21 durch eine schräge Schraffierung gekennzeichnet, die von links unten nach rechts oben verläuft. In den Figuren 4A, 4B, 5A und 5B ist die zweite Schließbacke 22 der zweiten Aufnahme 20 durch eine Schraffierung gekennzeichnet, die von links oben nach rechts unten verläuft.

Die zweite Schließbacke 22 kann als Teil des Hebels 30 ausgebildet sein. Innerhalb der zweiten Schließbacke 22 ist zumindest eine Andrückfederung 26A, 26B und/oder 26C angeordnet. Die Andrückfederung 26A, 26B und 26C drückt in der Betriebsposition die zweite Seitenkante 120 der Leiterplatte 100 über eine Andruckfläche der zweiten Schließbacke 22 an die zweite Auflagebacke 21. Die Andrückfederung stellt somit eine ähnliche Konstruktion wie die "floating base" der ersten Aufnahme bereit.

Die zweite Aufnahme 20 ist zumindest zweiteilig aufgebaut und weist dazu die zweite Auflagebacke 21 und die zweiten Schließbacke 22 auf, zwischen denen die Leiterplatte 100 eingeklemmt werden kann.

Die zweite Schließbacke 22 weist zumindest zwei gegeneinander auslenkbare Bauteile auf, die wegen einer Vorspannung gegeneinander über einen Spalt voneinander beabstandet sind. Diese Vorspannung innerhalb der zweiten Schließbacke 22 wird durch Andrückfederungen 26A, 26B und 26C bereitgestellt, die im Inneren der zweiten Schließbacke 22 angeordnet sind. In der Betriebsposition werden die beiden Bauteile der zweiten Schließbacke 22 so aneinander gedrückt, dass die zweite Seitenkante 120 fest in einem Klemmsitz in der zweiten Aufnahme 20 gehalten wird.

Mittig in der zweiten Auflagebacke 21 ist ein Führungspin 24 angeordnet, der in Sollposition der Leiterplatte 100 in den Einführspalt 122 an der zweiten Seitenkante 120 der Leiterplatte 100 eingreift. Der Führungspin 24 dient zur Ausrichtung der zweiten Seitenkante der Leiterplatte 100 in deren Sollposition, im Ausführungsbeispiel also in einer mittigen Position.

In der zweiten Schließbacke 22 der zweiten Aufnahme 20 ist eine Pinaufnahme 25 als ein Spalt ausgebildet, in die der Führungspin 24 in der Betriebsposition eingreifen kann.

**Figur 5A** zeigt einen Querschnitt durch die Leiterplatte 100 und den Testkontaktor 1, und zwar von der ersten Seitenkante 110 längs durch die Leiterplatte 100 bis hin zur zweiten Seitenkante 120, wobei der Testkontaktor in der Offenposition angeordnet ist und die Leiterplatte in der Sollposition.

**Figur 5B** zeigt denselben Querschnitt in Betriebsposition des Testkontaktors 1.

In diesem Querschnitt ist zu sehen, dass die zweite Auflagebacke 21 im Wesentlichen L-förmig aufgebaut ist und sowohl eine Kantenauflage 21A als auch eine Hebelauflage 21B aufweist. Dabei steht die Hebelauflage 21B senkrecht nach oben über die Kantenauflage 21A hinaus.

Die erste Auflage 21 weist weiterhin zumindest eine schräge Rutschfläche 28 auf, die von der Hebelauflage 21B weg abgeschrägt zur Kantenauflage 21A angeordnet ist. Falls beim Schließen des Hebels 30 die zweite Schließbacke 22 auf der Rutschfläche 28 aufkommt, führt die Rutschfläche 28 die zweite Schließbacke 22 von Richtung der Hebelauflage 21B aus auf die Kantenauflage 21A, auf der in Sollposition die Leiterplatte 100 aufliegt.

Die Rutschfläche 28A dient auch zum leichteren Einbringen der Leiterplatte 100 in die in den Figuren gezeigte Sollposition.

Zum Einbringen der Leiterplatte 100 kann diese zuerst mit der ersten Seitenkante 110 voran in den Spalt 15 der ersten Aufnahme 10 eingebracht werden, woraufhin die zweite Seitenkante 120 der Leiterplatte 100 auf die Rutschfläche 28 aufgelegt werden kann, von wo aus sie allein durch ihre Gewichtskraft herunter rutscht auf die Kantenauflage 21A der zweiten Auflagebacke 21.

Dies ermöglicht ein sehr komfortables und schnelles Einbringen der Leiterplatte in den Testkontaktor.

In der Offenposition des Testkontaktors dienen die erste Auflagebacke 11 der ersten Aufnahme und die zweite Auflagebacke 21 der zweiten Aufnahme 20 als zwei Sockel, auf denen die Leiterplatte 100 aufliegt. Dabei liegt die Leiterplatte 100 lediglich mit der ersten Seitenkante 110 und der zweiten Seitenkante 120 auf dem Testkontaktor 1 auf. Dazwischen ist eine Vertiefung 70 angeordnet, über der die Leiterplatte 100 mit ihrem Mittelteil schwebt.

Der Rasthaken 27 ist am Hebelende 32 ausgebildet und um eine Rastachse 27A schwenkbar, die parallel zur Schwenkachse 33 ausgerichtet ist, sowie parallel zu der ersten und zweiten Seitenkante der Leiterplatte 100 in Sollposition. Weiterhin ist die Rastachse 27A parallel zu den Auflageflächen der Aufnahmen 10 und 20 angeordnet und verläuft im Wesentlichen horizontal. Der Rasthaken 27 weist an seiner Spitze eine Rastnase 27B auf, die beim Schließen des Hebels 30 den Rasthaken 27 um die Rastachse 27A verschwenkt und auslenkt. Eine Rastfederung 27C stellt eine Vorspannung bereit, die den Rasthaken 27 in der in Figur 5A gezeigten Grundhaltung vorspannt. Beim Schließen des Hebels 30 drückt die Rastnase 27B auf einen Rastvorsprung 29 der ersten Aufnahme 10, wodurch der Rasthaken 27 solange ausgelenkt wird, bis der Hebel 30 in Betriebsposition ist, in der der Rasthaken 27 aufgrund der Vorspannung zurückschwenkt und die Rastnase 27B den Rastvorsprung 29 umgreift. In dieser Position verhindert der Rasthaken 27 ein Öffnen des Hebels 30.

Der Rasthaken 27 weist an seinem der Rastnase 27B bezüglich der Rastachse 27A gegenüberliegenden Ende einen Druckvorsprung 27D auf. Um den Testkontaktor 1 von der Betriebsposition aus zu öffnen, kann der Druckvorsprung 27D mit Druck beaufschlagt werden. Der Druck erfolgt gegen die Vorspannung der Rastfederung 27C und bewirkt ein Verschwenken des Rasthakens 27 um die Rastachse 27A, wobei die Rastnase 27B soweit ausgelenkt wird, dass sie nicht mehr den Rastvorsprung 29 der zweiten Aufnahme 20 umgreift. In dieser Position kann der Hebel 30 bequem in die Offenposition geschwenkt werden.

Der Hebel 30 weist zumindest einen Hebelarm 31 auf, der als Rahmen ausgebildet sein kann (vgl. Fig. 1A und 1B).

An dem Ende des Hebels 30, das der Schwenkachse 33 am nächsten liegt, kann am Hebel 30 ein Druckvorsprung 34 ausgebildet sein, der in der Betriebsposition von oben auf die erste Schließbacke 12 der ersten Aufnahme 10 drückt und einen Klemmsitz bereitstellt für die erste Seitenkante 110 der Leiterplatte 100, die in Betriebsposition zwischen der ersten Auflagebacke 11 und der ersten Schließbacke 12 gehalten wird.

Die erste Aufnahme 10 und/oder die zweite Aufnahme 20 kann zumindest eine abgefederte Andrückfläche aufweisen. Eine solche abgefederte Andrückfläche kann durch eine zweiteilige, gegeneinander abgefederte Ausbildung einer der beiden Klemmbacken (also entweder der Auflagebacke oder der Schließbacke oder beiden) bereitgestellt werden, zwischen denen die Leiterplatte in der Betriebsposition des Testkontaktors eingeklemmt ist. Die abgefederte Andrückfläche kann insbesondere als abgefederte Auflagefläche ausgebildet sein.

In dem in den Figuren dargestellten Ausführungsbeispiel wird eine abgefederte Andrückfläche zum Beispiel durch die zweite Schließbacke 22 der zweiten Aufnahme 20 mittels der Andrückfederung 26A, 26B und 26C bereitgestellt. In der ersten Aufnahme 10 kann eine abgefederte Andrückfläche sowohl in der ersten Auflagebacke als auch der ersten Schließbacke vorgesehen sein. Alternativ kann hier auch jeweils lediglich eine Andrückfläche abgefedert ausgebildet sein. In der Auflagebacke ist die abgefederte Andrückfläche als abgefederte Auflagefläche ausgebildet und stellt eine "floating base" bereit für einen besonders günstige Lagerung der Leiterplatte.

### Bezugszeichenliste

- 1: Testkontaktor
- 10: erste Aufnahme
- 11: erste Auflagebacke
- 12: erste Schließbacke
- 13A: Fixierpin
- 13B: Fixierpin
- 14A: Führungspin
- 15: Spalt
- 16A: Öffnungsfederelement
- 16B: Öffnungsfederelement
- 17A: Federung
- 17B: Federung
- 20: zweite Aufnahme
- 21: zweite Auflagebacke
- 21A: Kantenauflage
- 21B: Hebelauflage
- 22: zweite Schließbacke
- 23: zweites Kontaktelement
- 24: Führungspin
- 25: Pinaufnahme
- 26A: Andrückfederung
- 26B: Andrückfederung
- 26C: Andrückfederung
- 27: Rasthaken
- 27A: Rastachse
- 27B: Rastnase
- 27C: Rastfederung
- 27D: Druckvorsprung
- 28: Rutschfläche
- 29: Rastvorsprung
- 30: Hebel
- 31: Hebelarm
- 32: Hebelende
- 33: Schwenkachse
- 34: Druckvorsprung
- 40: Kabel
- 50: Testkontaktorboden
- 51: erste Bodenkante
- 52: zweite Bodenkante
- 60: Datenkabel
- 70: Vertiefung
- 100: Leitplatte
- 110: erste Seitenkante
- 111: erster Platinenrandkontakt
- 112A: Einführspalt
- 112B: Einführspalt
- 112C: Einführspalt
- 113A: Fixieröffnung
- 113B: Fixieröffnung
- 120: zweite Seitenkante
- 121: zweiter Platinenrandkontakt
- 122: Einführspalt
- 123A: Fixieröffnung
- 123B: Fixieröffnung
- H: Hubhöhe

## Patentansprüche

1. Testkontaktor (1) zum Kontaktieren einer Leiterplatte (100) mit
- einer ersten Aufnahme (10) zum Aufnehmen einer ersten Seitenkante (110) der Leiterplatte (100), wobei die erste Aufnahme (10) zumindest ein erstes Kontaktelement zum Kontaktieren eines ersten Platinenrandkontakts (111) an der ersten Seitenkante (110) der Leiterplatte (100) aufweist
und
- einer zweiten Aufnahme (20) zum Aufnehmen einer zweiten Seitenkante (120) der Leiterplatte (100), wobei die zweite Aufnahme (20) zumindest ein zweites Kontaktelement (23) zum Kontaktieren eines zweiten Platinenrandkontakts (121) an der zweiten Seitenkante (120) der Leiterplatte (100) aufweist;
wobei die erste Aufnahme (10) Fixierpins (13A, 13B) aufweist zum Eingreifen in Fixieröffnungen (113A, 113B) an der ersten Seitenkante (110) der Leiterplatte (100).

2. Testkontaktor nach Anspruch 1, wobei die erste Aufnahme (10) und die zweite Aufnahme (20) an bezüglich der Leiterplatte (100) gegenüberliegenden Seiten angeordnet sind.

3. Testkontaktor nach Anspruch 1 oder 2, wobei in einer Offenposition des Testkontaktors (1) die erste Aufnahme (10) und die zweite Aufnahme (20) geöffnet sind, so dass die Leiterplatte (100) in die erste Aufnahme (10) und zweite Aufnahme (20) einbringbar ist, und wobei in einer Betriebsposition des Testkontaktors (1) die erste Aufnahme (10) und die zweite Aufnahme (20) geschlossen sind, so dass die Leiterplatte (100) mechanisch gegen Entnahme aus dem Testkontaktor (1) gesichert ist.

4. Testkontaktor nach Anspruch 3, wobei die erste Aufnahme (10) und zweite Aufnahme (20) zumindest teilweise sockelartig ausgebildet sind, so dass die Leiterplatte (100) in der Offenposition im Wesentlichen horizontal auf die erste Aufnahme (10) und zweite Aufnahme (20) auflegbar ist.

5. Testkontaktor nach Anspruch 3 oder 4, mit einem Hebel (30), wobei eine Betätigung des Hebels (30) den Testkontaktor (1) von der Offenposition in die Betriebsposition überführt.

6. Testkontaktor nach Anspruch 5, wobei die erste Aufnahme (10) an einer Schwenkachse (33) des Hebels (30) ausgebildet ist.

7. Testkontaktor nach Anspruch 5 oder 6, wobei die zweite Aufnahme (20) in der Betriebsposition von einem Hebelende (32) des Hebels (30) geschlossen ist.

8. Testkontaktor nach einem der Ansprüche 5 bis 7, mit einem federndem Rasthaken (27), der den Hebel (30) in der Betriebsposition sichert und bei Druckbeaufschlagung freigibt.

9. Testkontaktor nach einem der Ansprüche 5 bis 8, mit einem Federelement, das eine Kraft auf den Hebel (30) in diejenige Hebelposition ausübt, in der der Testkontaktor (1) in der Offenposition angeordnet ist
und/oder
wobei der Hebel (30) als schwenkbarer Deckel des Testkontaktors (1) ausgebildet ist.

10. Testkontaktor nach einem der vorangegangenen Ansprüche, wobei die zweite Aufnahme (20) dazu ausgebildet und vorgesehen ist, den zweiten Platinenrandkontakt (121) mit einer Stromquelle zu verbinden
und/oder
wobei die zweite Aufnahme (20) zumindest eine schräge Rutschfläche (28) aufweist.

11. Testkontaktor nach einem der vorangegangenen Ansprüche, wobei an der ersten Aufnahme (10) zumindest ein Pin (13A, 13B, 14A) zur Ausrichtung der ersten Seitenkante (110) der Leiterplatte (100) in der ersten Aufnahme (10) angeordnet ist.

12. Testkontaktor nach einem der vorangegangenen Ansprüche, wobei an der zweiten Aufnahme (20) zumindest ein Pin (24) zur Ausrichtung der zweiten Seitenkante (120) der Leiterplatte (100) in der zweiten Aufnahme (20) angeordnet ist.

13. Testkontaktor nach Anspruch 7 und 12, wobei der Pin (24) zur Ausrichtung der zweiten Seitenkante (120) der Leiterplatte (100) in der Betriebsposition in einen Eingriff (25) am Hebelende (32) eingreift.

14. Verwendung eines Testkontaktors (1) gemäß einem der vorangegangenen Ansprüche zum Kontaktieren einer Leiterplatte (100), wobei die erste Seitenkante (110) der Leiterplatte (100) in der ersten Aufnahme (10) angeordnet ist und die zweite Seitenkante (120) der Leiterplatte (100) in der zweiten Aufnahme (20) angeordnet ist.

15. Verfahren zum Prüfen einer Leiterplatte (100) mit den Schritten:
- Bereitstellen eines geöffneten Testkontaktors (1) gemäß einem der Ansprüche 1 bis 15;
- Anordnen einer Leiterplatte (100) derart, dass die erste Seitenkante (110) der Leiterplatte (100) in der ersten Aufnahme (10) angeordnet ist und die zweite Seitenkante (120) der Leiterplatte (100) in der zweiten Aufnahme (20);
- Schließen des Testkontaktors (1) derart, dass das erste Kontaktelement den ersten Platinenrandkontakt (111) kontaktiert und das zweite Kontaktelement (23) den zweiten Platinenrandkontakt (121) kontaktiert, wobei Fixierpins (13A, 13B) in Fixieröffnungen (113A, 113B) an der ersten Seitenkante (110) der Leiterplatte (100) eingreifen;
- Prüfen der Leiterplatte (100);
- Öffnen des Testkontaktors (1) und
- Entnehmen der Leiterplatte (100).

## Claims

1. A test contactor (1) for contacting a circuit board (100), having
- a first receptacle (10) for receiving a first lateral edge (110) of the circuit board (100), wherein the first receptacle (10) has at least one first contact element for contacting a first board edge contact (111) at the first lateral edge (110) of the circuit board (100)
and
- a second receptacle (20) for receiving a second lateral edge (120) of the circuit board (100), wherein the second receptacle (20) has at least one second contact element (23) for contacting a second board edge contact (121) at the second lateral edge (120) of the circuit board (100);
wherein the first receptacle (10) has fixing pins (13A, 13B) for engaging in fixing openings (113A, 113B) at the first lateral edge (110) of the circuit board (100).

2. The test contactor according to Claim 1, wherein the first receptacle (10) and the second receptacle (20) are arranged on opposite sides with respect to the circuit board (100).

3. The test contactor according to Claim 1 or 2, wherein, in an open position of the test contactor (1), the first receptacle (10) and the second receptacle (20) are open such that the circuit board (100) can be introduced into the first receptacle (10) and second receptacle (20), and wherein, in an operating position of the test contactor (1), the first receptacle (10) and the second receptacle (20) are closed such that the circuit board (100) is mechanically secured against being removed from the test contactor (1).

4. The test contactor according to Claim 3, wherein the first receptacle (10) and second receptacle (20) are at least partially configured in the manner of a holder such that the circuit board (100) can be placed substantially horizontal on the first receptacle (10) and second receptacle (20) in the open position.

5. The test contactor according to Claim 3 or 4, having a lever (30), wherein an actuation of the lever (30) transfers the test contactor (1) from the open position into the operating position.

6. The test contactor according to Claim 5, wherein the first receptacle (10) is configured on a pivoting axis (33) of the lever (30).

7. The test contactor according to Claim 5 or 6, wherein the second receptacle (20) is closed in the operating position of a lever end (32) of the lever (30).

8. The test contactor according to any one of Claims 5 to 7, having an elastic latching hook (27) which secures the lever (30) in the operating position and releases it when pressure is applied.

9. The test contactor according to any one of Claims 5 to 8, having a spring element which exerts a force on the lever (30) in that lever position, in which the test contactor (1) is arranged in the open position,
and/or
wherein the lever (30) is configured as a pivotable lid of the test contactor (1).

10. The test contactor according to any one of the preceding claims, wherein the second receptacle (20) is configured and provided to connect the second board edge contact (121) to a power source,
and/or
wherein the second receptacle (20) has at least one oblique sliding surface (28).

11. The test contactor according to any one of the preceding claims, wherein at least one pin (13A, 13B, 14A) for aligning the first lateral edge (110) of the circuit board (100) in the first receptacle (10) is arranged on the first receptacle (10).

12. The test contactor according to any one of the preceding claims, wherein at least one pin (24) for aligning the second lateral edge (120) of the circuit board (100) in the second receptacle (20) is arranged on the second receptacle (20).

13. The test contactor according to Claim 7 and 12, wherein the pin (24) for aligning the second lateral edge (120) of the circuit board (100) engages in an engagement (25) at the lever end (32) in the operating position.

14. Use of a test contactor (1) according to any one of the preceding claims for contacting a circuit board (100), wherein the first lateral edge (110) of the circuit board (100) is arranged in the first receptacle (10) and the second lateral edge (120) of the circuit board (100) is arranged in the second receptacle (20).

15. A method for testing a circuit board (100) having the steps of:
- providing an opened test contactor (1) according to any one of Claims 1 to 15;
- arranging a circuit board (100) in such a manner that the first lateral edge (110) of the circuit board (100) is arranged in the first receptacle (10) and the second lateral edge (120) of the circuit board (100) is arranged in the second receptacle (20);
- closing the test contactor (1) in such a manner that the first contact element contacts the first board edge contact (111) and the second contact element (23) contacts the second board edge contact (121), wherein fixing pins (13A, 13B) engage in fixing openings (113A, 113B) at the first lateral edge (110) of the circuit board (100);
- testing the circuit board (100);
- opening the test contactor (1), and
- removing the circuit board (100).

## Revendications

1. Contacteur d'essai (1) servant à connecter une carte de circuits imprimés (100) doté
- d'un premier logement (10) pour recevoir un premier bord latéral (110) de la carte de circuits imprimés (100), dans lequel le premier logement (10) présente au moins un premier élément de contact pour connecter un premier contact latéral de carte de circuits imprimés (111) sur le premier bord latéral (110) de la carte de circuits imprimés (100)
et
- d'un second logement (20) pour recevoir un second bord latéral (120) de la carte de circuits imprimés (100), dans lequel le second logement (20) présente au moins un second élément de contact (23) pour connecter un second contact latéral de carte de circuits imprimés (121) sur le second bord latéral (120) de la carte de circuits imprimés (100) ;
dans lequel le premier logement (10) présente des broches de fixation (13A, 13B) destinées à s'engager dans des ouvertures de fixation (113A, 113B) sur le premier bord latéral (110) de la carte de circuits imprimés (100).

2. Contacteur d'essai selon la revendication 1, dans lequel le premier logement (10) et le second logement (20) sont disposés sur des côtés opposés par rapport à la carte de circuits imprimés (100).

3. Contacteur d'essai selon la revendication 1 ou 2, dans lequel le premier logement (10) et le second logement (20) sont ouverts dans une position ouverte du contacteur d'essai (1), de sorte que la carte de circuits imprimés (100) peut être introduite dans le premier logement (10) et le second logement (20), et dans lequel le premier logement (10) et le second logement (20) sont fermés dans une position de fonctionnement du contacteur d'essai (1), de sorte que la carte de circuits imprimés (100) est sécurisée mécaniquement contre l'extraction hors du contacteur d'essai (1).

4. Contacteur d'essai selon la revendication 3, dans lequel le premier logement (10) et le second logement (20) sont conçus au moins pour partie en forme de socle, de sorte que la carte de circuits imprimés (100) peut être posée sensiblement à l'horizontale sur le premier logement (10) et sur le second logement (20) dans la position ouverte.

5. Contacteur d'essai selon la revendication 3 ou 4, doté d'un levier (30), dans lequel un actionnement du levier (30) fait passer le contacteur d'essai (1) de la position ouverte à la position de fonctionnement.

6. Contacteur d'essai selon la revendication 5, dans lequel le premier logement (10) est constitué sur un axe de pivotement (33) du levier (30).

7. Contacteur d'essai selon la revendication 5 ou 6, dans lequel le second logement (20) est fermé dans la position de fonctionnement par une extrémité (32) du levier (30).

8. Contacteur d'essai selon l'une des revendications 5 à 7, doté d'un crochet d'encliquetage à ressort (27), qui sécurise le levier (30) dans la position de fonctionnement et le débloque lorsqu'une pression lui est appliquée.

9. Contacteur d'essai selon l'une des revendications 5 à 8, doté d'un élément à ressort, qui exerce une force sur le levier (30) dans la position du levier, où le contacteur d'essai (1) est disposé dans la position ouverte
et/ou
dans lequel le levier (30) est conçu sous la forme d'un couvercle pivotant du contacteur d'essai (1).

10. Contacteur d'essai selon l'une des revendications précédentes, dans lequel le second logement (20) est conçu et prévu de manière à relier le second contact latéral de carte de circuits imprimés (121) à une source de courant
et/ou
dans lequel le second logement (20) présente au moins une surface de glissement oblique (28).

11. Contacteur d'essai selon l'une des revendications précédentes, dans lequel au moins une broche (13A, 13B, 14A) est disposée sur le premier logement (10) pour aligner le premier bord latéral (110) de la carte de circuits imprimés (100) dans le premier logement (10).

12. Contacteur d'essai selon l'une des revendications précédentes, dans lequel au moins une broche (24) est disposée sur le second logement (20) pour aligner le second bord latéral (120) de la carte de circuits imprimés (100) dans le second logement (20).

13. Contacteur d'essai selon les revendications 7 et 12, dans lequel la broche (24) servant à aligner le second bord latéral (120) de la carte de circuits imprimés (100) est en prise avec un engrènement (25) à l'extrémité du levier (32) dans la position de fonctionnement.

14. Utilisation d'un contacteur d'essai (1) selon l'une des revendications précédentes servant à connecter une carte de circuits imprimés (100), dans lequel le premier bord latéral (110) de la carte de circuits imprimés (100) est disposé dans le premier logement (10) et le second bord latéral (120) de la carte de circuits imprimés (100) est disposé dans le second logement (20).

15. Procédé de vérification d'une carte de circuits imprimés (100) présentant les étapes suivantes :
- fourniture d'un contacteur d'essai (1) ouvert selon l'une des revendications 1 à 15 ;
- disposition d'une carte de circuits imprimés (100) de telle sorte que le premier bord latéral (110) de la carte de circuits imprimés (100) est disposé dans le premier logement (10) et le second bord latéral (120) de la carte de circuits imprimés (100) dans le second logement (20) ;
- fermeture du contacteur d'essai (1) de telle sorte que le premier élément de contact connecte le premier contact latéral de carte de circuits imprimés (111) et le second élément de contact (23) connecte le second contact latéral de carte de circuits imprimés (121), dans lequel les broches de fixation (13A, 13B) s'engagent dans des ouvertures de fixation (113A, 113B) sur le premier bord latéral (110) de la carte de circuits imprimés (100) ;
- vérification de la carte de circuits imprimés (100) ;
- ouverture du contacteur d'essai (1) et
- enlèvement de la carte de circuits imprimés (100).
